# EUROPEAN PATENT SPECIFICATION

(11) **EP 1 447 858 B1**
(45) Date of publication and mention of the grant of the patent: **06.08.2008**
(21) Application number: 03002987.0
(22) Date of filing: 11.02.2003
(51) Int. Cl.: H01L 39/24

(54) **Reinforcement of superconducting coils**
Verstärkung für supraleitende Spule
Renforcement pour bobines supraconductrices

(43) Date of publication of application: 18.08.2004
(73) Proprietor: Pourrahimi, Shahin, Brookline, Massachusetts 02446 (US); Pourrahimi, Nadder, Marlborough, Massachusetts 01752 (US)
(72) Inventor: Pourrahimi, Shahin, Brookline, Massachusetts 02446 (US); Pourrahimi, Nadder, Marlborough, Massachusetts 01752 (US)
(74) Representative: Eder, Ephry

(56) References cited:
- EP-A- 1 033 726
- US-A- 5 319 843
- US-A- 5 364 709

## Description

### Field of the Invention

The present invention resides in the field of superconducting coils and more particularly relates to the reinforcement of superconducting coil magnets using composite superconducting wires that are clad with high-strength materials.

### History of the Prior Art

Superconductivity is the phenomenon where, when a particular material, such as a wire, is subjected to successively colder temperatures, it undergoes a state transition where all electrical resistance disappears, i.e. the material can conduct electricity without generating any heat. At this stage the material is said to have become a superconductor. This phenomenon only occurs for specific metals/alloys and compounds. The state of superconductivity for a given superconductor is a function of its temperature, background magnetic field, and transport electric current.

Superconducting magnets almost exclusively consist of windings of superconducting wire, also known as coils. In very large magnets the "wire" may take the form of cabled superconducting wires. For some superconducting magnets the cable of wires is contained, together with helium for cooling, in a metal conduit. All wires used in building such magnets include insulation that surrounds the wire to be wound. Turns and layers of the winding of a magnet are often bonded to each other by a bonding agent, such as epoxy. Such windings are said to be impregnated.

In many superconducting magnet applications, for example in nuclear magnetic resonance (NMR) and for magnetic resonance imaging (MRI), the windings are usually solenoids. Often NMR and MRI magnets are comprised of a number of solenoid coils that are electrically connected. The magnetic fields produced by the system of coils combine to produce an intended magnetic field intensity over an intended volume inside the system of coils of the magnet. The field intensity of a solenoid, as well as most other magnet configurations, scales with the number of turns of the wire that makes up the windings of the coil and the electric current (amperes) that passes through the wire. Often it is said that the field intensity scales with "ampere-turns." For reasons of: (1) minimizing space, (2) using less superconducting wire, and more importantly (3) reducing the stored energy of the coil, most coils used in magnets with high stored energy such as NMR and MRI magnets are designed and built such that a given coil is as compact as possible.

When current passes through the wire of a coil, a magnetic field is produced. When current passes through a system of coils, a combined magnetic field is produced. The magnetic field (B) which is produced by a coil or a system of coils around a given turn inside the winding volume (pack) of a coil interacts with the current in the wire and produces a force on the wire, referred to as the Lorentz Force. Because the orientation of the magnetic field varies according to the location of the turn within the coil, or system of coils, the direction of the force varies also. The Lorentz Forces are balanced by the wire and other materials that make up the coil, resulting in mechanical stresses in the wire. In a given solenoid coil the Lorentz Forces on the turns combine to produce two components of stress in the wire. A tensile hoop stress is developed in the wire of magnitude BxIxR where B is the local field strength, I is the current and R is the radius of curvature. A transverse stress is also incident because radial components of the field in regions of a winding produce an axial force. Of these components of stress the hoop stress is generally the more significant, but both must be considered in the structural design of a high field magnet. When a solenoid coil is charged by current passing through it, there is a balance between its electromagnetic energy and mechanical elastic energy. Therefore a charged coil, or a system of coils, stores energy.

Design parameters and conventional approaches to solenoid design are discussed, for example, in: Superconducting Magnets, M. N. Wilson, Oxford University Press, New York, New York (1983) and Case Studies in Superconducting Magnets, Y. Iwasa, Plenum Press, New York, New York (1994).

The stresses on the wires inside many superconducting coils may reach hundreds of MPa. Therefore a main part of the design optimization of coils is calculation of stresses and bearing of the stresses by the coil.

To achieve the highest possible fields inside the bore of many magnets, for example the NMR and MRI magnets, and most effectively support against Lorentz Forces, the wires used in these magnets are usually a solid monolithic wire, and their winding packs are devoid of any space for helium which is sometimes used as a heat sink inside the winding pack of some superconducting magnets. The coils of many superconducting magnets are comprised of solid matter. These are often referred to as being adiabatic coils as any release of local energy within the winding pack is absorbed by the winding pack itself first, and then it is transferred to the cooling medium that is external to the winding pack.

For reasons that relate to stability of superconductors, superconducting wires used in most magnet application are multifilamentary (MF) composites. [see for example Stability of Superconductor, by Lawrence Dresner, Plenum Press, New York, New York, 1995].

The superconducting filaments in MF wires in use in most superconducting magnets today are made from niobium-titanium (Nb-Ti) alloy. The Tc and Bc₂ for Nb-Ti filaments are about 10 Kelvin (K) and about 10 (T), respectively. Nb-Ti alloy is ductile and its use in fabricating MF wires, and subsequently in a magnet, is straightforward and comparatively less expensive than using other materials. MF Nb-Ti composite wires are often comprised of Nb-Ti filaments inside a copper or copper alloy matrix.

Superconducting magnets for operation at fields higher than about 10 T rely principally on the use of type A15 superconductors. Among the A15 superconductors the Nb₃Sn based wires are most practical for large-scale production, basically due to the fact that fabrication of Nb₃Sn is economical and less complicated. Almost all operating A15 magnets to date have used Nb₃Sn conductors. The Tc and Bc₂ for Nb₃Sn are about 18 Kelvin (K) and about 23 (T), respectively. Other A15 superconductors, such as Nb₃Al, that have better superconducting properties than Nb₃Sn are under development.

Nb₃Sn, like other A15 phases, is an intermetallic compound and is inherently brittle. Therefore it does not lend itself to normal conductor fabrication methods where a given material undergoes significant plastic deformation. For most applications in magnet technology, Nb₃Sn superconductors are produced by a two-step process in which a multifilamentary composite wire, that contains Nb and Sn in separate regions, is formed into wire (Nb₃Sn precursor wire) and then, during a subsequent reaction heat treatment at, for example 650C-750C, the Nb₃Sn is formed by solid state reaction. MF Nb₃Sn composite wires are often comprised of Nb₃Sn filaments inside a copper and bronze alloy matrix. Because Nb₃Sn is brittle, windings of Nb₃Sn wire are often produced by winding un-reacted wires and then heat-treating the winding as a whole. This approach is referred to as the wind-then-react method. If the winding diameter is large enough the winding can be performed using a reacted Nb₃Sn wire. This approach is referred to as react-then-wind method. Because MF Nb₃Sn wires have to be heat-treated at temperatures of 650C-750C, the non-superconducting matrix in the wires which is most often copper or bronze is in a fully annealed state and is therefore mechanically weak and cannot contribute much to the bearing of Lorentz Forces. Therefore it is particularly desirable to reinforce Nb₃Sn wires and coils for superconducting magnet applications.

A main challenge of design and manufacturing coils with high stored energy, for example for NMR and MRI magnets, is to minimize the size of the coils by using conductors that have enough superconducting material to provide the required ampere-turns and optimizing/minimizing structural material to bear the mechanical stresses.

Up to the present time the following methods have been used to reinforce the coils/wires of magnets that use MF wires:
- extra cold worked (hard) copper has been incorporated into the wire wherein the non-superconducting part of a wire that carries no current is increased and therefore the ampere-turns for a given winding pack is decreased;
- winding sections have been over-banded with a strong material, including steel, beryllium copper, carbon fiber, etc.; and
- attempts have been made to incorporate reinforcements in addition to the use of copper and copper alloys inside superconducting wires.

One disadvantage to the use of hard copper as the reinforcement is that the strength of hard copper is limited to about 275 MPa (40,000 psi) in consequence of which in many magnet windings more copper is needed for reinforcement than for stabilization. The result is a lower overall winding current density than could be obtained with the separation of functions, that is, enough copper for stabilization or quench protection and enough high-strength reinforcement for stress containment. A disadvantage of overbanding is that high radial strain in the active winding is needed to transfer the electromagnetic loads to the overbanding. The most efficient and compact winding is obtained when the reinforcement is distributed throughout the active winding. Variations in distributing reinforcement throughout the active winding, though, can create disadvantages inside a superconducting wire in that it complicates the wire manufacturing process for both Nb-Ti and Nb₃Sn MF wires because the reinforcing material needs to be both mechanically compatible with the wire manufacturing process which limits the choice of materials as such materials must also be chemically inert to the chemistry of the superconducting wires.

Other prior art disclosing methods of cladding superconducting wire includes US-3714371, US-3767842 and EP-10033726. For example EP-10033726 which is considered to represent the closest prior art discloses cladding superconducting wire with pure aluminum and aluminum alloys to provide for increased stability and mechanical reinforcement by the use of Al-Ni alloys with more than 97% aluminum for improve yield strength. While such cladding can be useful to some application where combination of reduction of weight and stability are of primary concern, use of aluminum and its alloys with elastic moduli of about 70 GPa and yield strength of typically less than 200 MPa are not preferred in manufacturing of the type of magnets discussed above for use in NMR and MRI.

### Summary of the Invention

The present patent application is concerned with the provision of stronger reinforcing materials suitable to create coil windings having great resistance to the aforementioned stresses.

According to a first aspect of this invention there is provided a method of manufacturing a conductor for a coil intended to be superconductive in operation, comprising the steps of:
(a) providing a conductor having a composite core of superconductor filaments in a matrix of copper metal or alloy, and
(b) cladding the core with a layer of a high-strength reinforcement material
characterised in that said material has an elastic modulus higher than that of pure copper, and in that the step of cladding includes at least partially surrounding the core by folding said layer about the core.

By the term "high-strength reinforcing material" as used herein is meant a material having a mechanical yield strength and and an elastic modulus higher than those of pure copper.

According to a second aspect of this invention there is provided a conductor for a coil intended to be superconductive in operation, the conductor being produced by a method according to said first aspect of this invention and having features as set out in Claim 10.

According to a third aspect of this invention there is provided a coil intended to be superconductive in operation, said coil comprising a winding formed of at least one conductor according to said second aspect of this invention.

Preferably, the composite core is formed of NbTi-copper, Nb₃Sn-copper or an A 15 superconductor filaments-copper, and the cladding is formed of steel or an alloy thereof, of nickel or an alloy thereof, of superalloy, of stainless steel, of molybdenum metal or an alloy thereof, or of another refractory metal or an alloy thereof.

Advantageously said cladding is applied by at least partially surrounding the composite core without forming voids between the cladding and the composite core.

After forming the cladding around the core, the clad core may be formed into a shape having a circular cross-section or a substantially rectangular cross-section.

In embodiments of this invention a reinforcement is incorporated directly on a MF superconducting composite wire as cladding. This is done after MF superconducting wire fabrication is nearly completed. It is assumed that insulation is selected and applied appropriately on the superconducting wires. In this way, when the reinforced wire is wound into a coil, the structural support is well distributed throughout the winding.

Embodiments of the present invention also contemplate that adiabatic superconducting magnets are prone to instability arising from thermal transients within the winding. For example, when the bonding agent used in the winding pack of a coil cracks as a result of straining associated with cooling, motion against fixtures, or charging of the magnets, heat arises in the winding pack, producing a temperature pulse that diffuses into the superconducting material in the core of wire and may raise the temperature locally above the current sharing temperature. The result may be a premature loss of superconductivity. referred to as quench. For a given heat pulse, the temperature rise is a function of the heat conductivity and heat capacity of the material affected by the heat pulse. In contrast to conventional winding packs that use copper or copper alloys on the surface of the wires, in this invention the wires are clad by materials of lower thermal conductivity, such as steel alloy, therefore the diffusion of heat into the core of wire will be impeded and heat diffused to a wider region affecting a relatively larger mass. For example, a steel-clad wire is more resistant to thermal transient than a wire with copper at the outer surface. Furthermore, steel being tough and rigid, protects the wire from abuse more efficiently than prior art outer surface materials, such as copper.

Cladding with an appropriate high-strength material is particularly apposite for a Nb₃Sn wire which has been reacted before winding. Indeed, the clad Nb₃Sn wire may make "react-then-wind" magnets much more practical than at present. It should be understood that Nb₃Sn is discussed only as an example of A15 superconductor and the principals of invention is considered applicable to all MF A15 wires.

The method discussed here is also considered applicable to High Temperature Superconductors (HTS) including those belonging to Bismuth-based 2212, 2223, or Yttrium-based 123 compounds MgB₂ Based superconducting wires. Since magnets that use these materials are still in the developmental stages they are not further mentioned in the discussions here.

### Brief Description of the Drawings

By way of example embodiments of this invention will now be described with reference to the accompanying drawings of which:
- Figure 1: illustrates a cross-sectional view through a multifilamentary wire of the prior art.
- Figure 2: illustrates a cross-sectional view through a reinforced wire of this invention in which steel takes the form of a sheath around the outer surface of the superconductor-copper composite wire.
- Figure 3: illustrates a cross-sectional view through a prior art conductor configuration with a known superconducting current carrying capacity and mechanical strengths.
- Figure 4: illustrates a cross-sectional view of a steel-clad superconducting wire according to this invention and of equivalent strength to the prior art wire of Figure 3.
- Figure 5: illustrates a cross-sectional view of another embodiment of a steel-clad superconducting wire according to this invention and having a different cross-sectional shape.
- Figure 6: illustrates a cross-sectional view through a multifilamentary superconducting wire with a reinforcing cladding and a high conductivity cladding incorporating an embodiment of the present invention.

### Description of Preferred Embodiment(s)

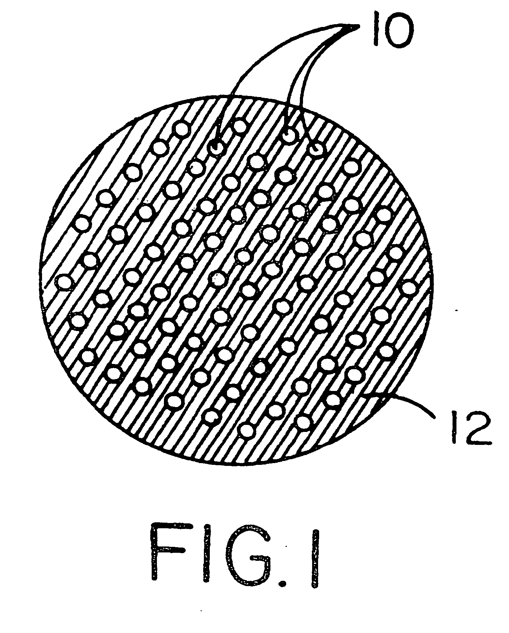

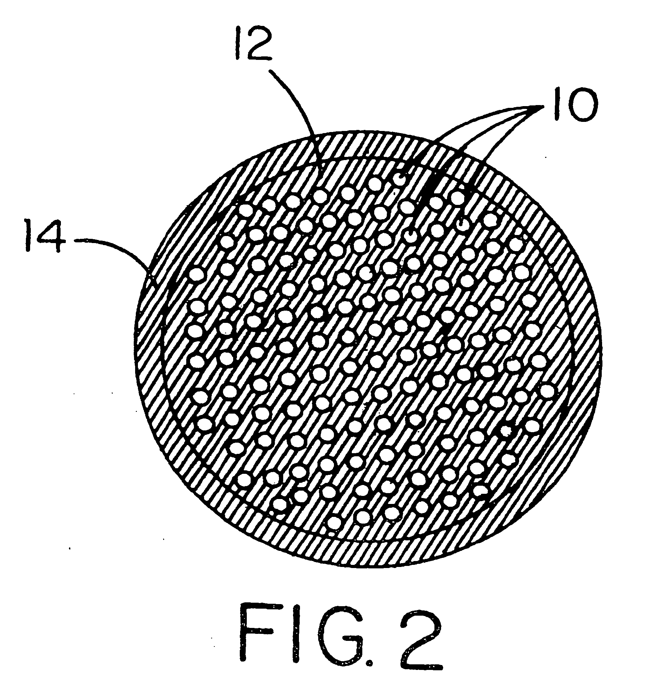

Figure 1 illustrates a cross-sectional view of prior art composite wires 10 made of filamentary Nb-Ti or Nb₃Sn within a copper or copper alloy matrix 12. Figure 2 illustrates a cross-sectional view of a similar wire to that of Figure 1 but surrounded with stainless steel reinforcing material 14. The steel takes the form of a sheath over the composite wire. This arrangement differs from that of the so-called cable-in-conduit superconductor (CiCC) in that no void space unfilled with metal is left in the cross section. Where the superconductor is composed of Nb-Ti, manufacturing processes can include the following: Nb-Ti-copper composite wire of a given diameter and length is clad by a given layer of steel by folding a continuous sheet of the steel. In some applications the seam of the folded sheet of steel may be welded by a continuous operation. The steel cladding is then drawn over the Nb-Ti-copper wire to provide intimate contact and achieve a final target diameter and geometry. For Nb₃Sn wires the cladding procedure is the same as above but the steel cladding is put on the Nb₃Sn precursor wire before heat treatment. Therefore in the steel selection one should be mindful of the effect of heat treatment on the properties of the particular steel and inter-diffusion of element of the cladding and the core Nb₃Sn wire, and its magnetic properties.

For reasons relating to particular resistivity of the cladding, and/or compatibility of the cladding material with the core material during heat treatment, and relative mechanical behavior the cladding and the core, the choice of cladding materials may be among molybdenum, niobium, vanadium, tantalum, or their alloys. For example, molybdenum is particularly useful for cladding of Nb₃Sn wires as it has no appreciable mutual solubility with copper and doesn't react with typical Nb₃Sn wires during their reaction heat treatment. In addition, molybdenum has a relatively high elastic modulus and is particularly effective in reinforcing magnets made from Nb₃Sn or any other superconducting wire.

Aside from benefits in mechanical performance of magnets, a reinforcing cladding may improve the stability of some magnets. A stable adiabatic magnet must have no sources of temperature excursion greater than the temperature margin of operation. It is known that temperature perturbations arise from cracking of epoxy impregnation or frictional movement between a winding and its surrounding form. Temperature rise may also result from the decay of induced shielding currents, but that is a negligible effect during normal charge. The elimination or at least the minimization of these triggers is essential in the design and construction of the magnet. The specification of the temperature margin has hitherto been based principally on design experience. The quantitative specification of temperature margin which usually is specified as the margin between operating current and critical current is complex, because the perturbations that may cause temperature excursions are ill defined. However, in the present invention the use of a generous amount of a high residual resistivity ratio (RRR) normal conductor, e.g. copper, is not essential for stability, and furthermore, it is not essential or even desirable, for quench protection. For example, in the case where a central core containing the superconducting filaments is surrounded by a low RRR copper sheath, which in turn is surrounded by a high-strength reinforcement and where a frictional or mechanical perturbation occurs at the outer surface of this combination, the high-strength sheath acts to provide high thermal resistance. The heat generated at its outer surface diffuses slowly inwards and meets the low RRR copper annulus. This conductor has high conductivity so that the heat issuing from the reinforcement diffuses axially as well as radially. This heat diffusion results in a much attenuated heat pulse entering the core. Although the copper sheath provides little longitudinal electrical conductivity, because its RRR is low, its relative conductivity is still high when compared with the matrix of the core. Thus, this combination will provide almost as good a stabilizing effect as a high RRR sheath. It is important to note that, with one exception, all perturbations produce heat pulses which diffuse inwards from the outside of the conductor, not from the core outwards. The exception is a flux jump caused by the collapse of shielding currents, but such an event is rare in a wire of appropriate twist pitch. Thus, if a perturbation occurs which raises the temperature of the superconducting filaments to just below the current sharing temperature, no current flows in the copper. If, however, the temperature exceeds the current sharing temperature, then current will flow in the copper. Whether the superconductor recovers from the subsequent transient then depends largely on the thermal conductivity of the copper, because longitudinal heat transport is then the only mechanism that can remove heat faster than it is generated. Thus, a composite conductor that includes both (1) a high-strength, high-resistivity cladding and (2) copper positioned in between the cladding and the superconducting filaments is preferred for optimized adiabatic superconducting coils.

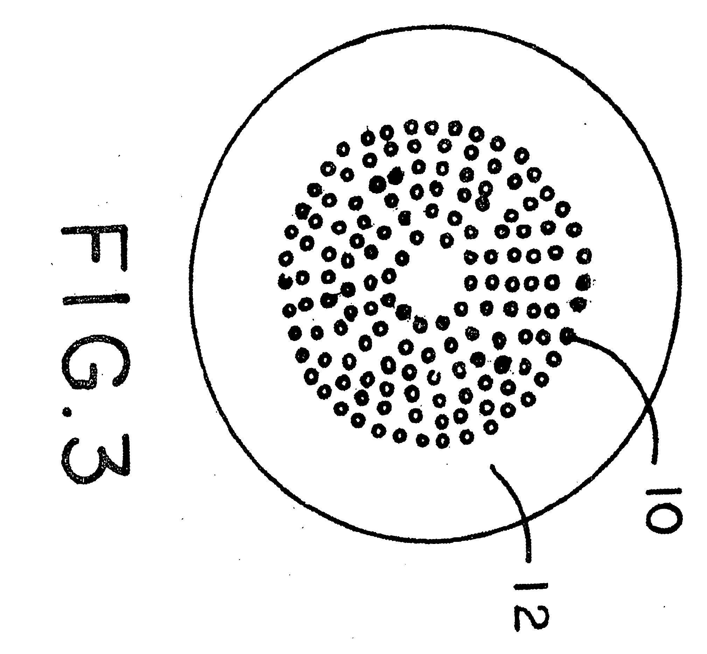

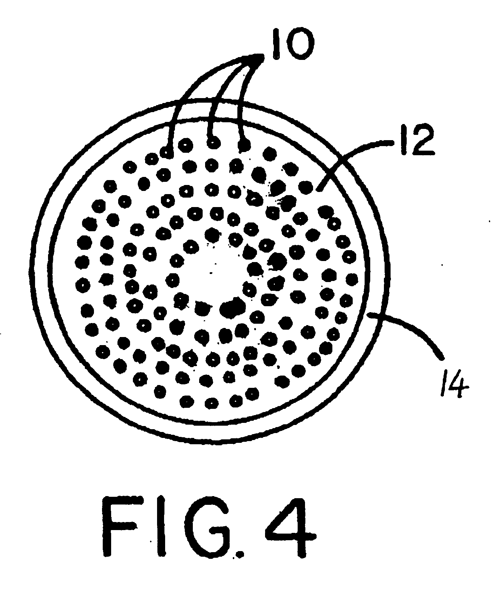

Essential to the composition of the conductor is a sufficient normal conductor to provide the necessary quench protection. A combination of structure and stabilizer to be incorporated into the conductor could be, for example, stainless steel 316LN that has high elastic modulus, 200 GPa and high yield strength (up to 1.6 GPa for fully hard wires) and therefore much less of it is required to provide the same structural support as hard copper (elastic modulus of 130 GPa and strength of 0.4 Gpa). As an example of the use of the composite superconducting wire of this invention, first consider the prior art conductor that was used in the largest Nb-Ti coils of the 600 MHz magnet designed and built by J. Williams [J.E.C. Williams, S. Pourrahimi, Y Iwasa, and L.J. Neuringer, "A 600 MHz Spectrometer Magnet, "IEEE Trans. Vol. Mag-25, pp. 1767-1770, 1989]. The cross-section of this conductor is depicted in Fig. 3. The copper/superconductor ratio is 4/1. As an alternative the present invention provides the conductor shown in Fig. 4. This conductor has a core with a superconductor/copper ratio of 1/1 which has a stainless steel 316LN cladding 14. The conductors shown in Figs. 3 and 4 have equivalent mechanical properties and superconducting critical properties, that is , they can carry the same current at various fields, but the overall area of the conductor of this invention is about half that of the prior art conductor illustrated in Figure 3. Thus, by using the conductor of this invention the same ampere/turns can be achieved in a winding pack that is half as thick and weighs about half as much as the prior art conductor.

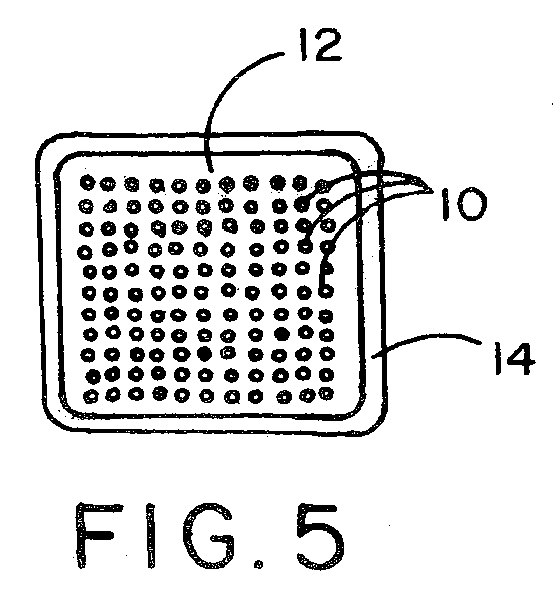

The use of superconducting wires having a square, or low aspect ratio rectangular, cross section has become a choice for fabrication of high performance NMR and MRI magnets. The conductor configuration illustrated in Fig. 5 has an equivalent cross-sectional area as that of the conductor illustrated in Fig. 4 but can achieve a higher overall critical current density for a given winding pack thickness, and is mechanically more robust.

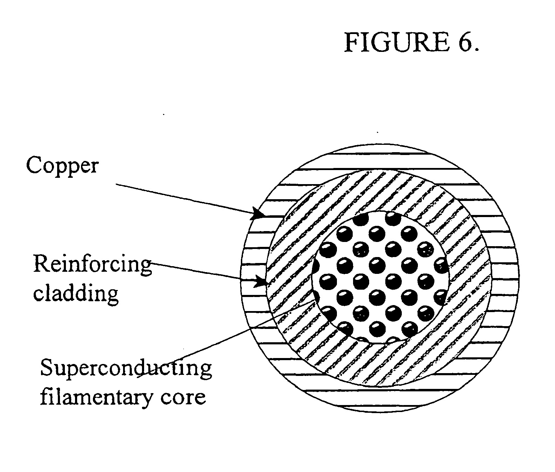

If in a particular application the design calls for high conductivity material on the surface of the wire, the reinforced wire, that is conductor with high strength cladding, may be clad with a high conductivity material like copper in a secondary process. Figure 6. shows a conductor with both a reinforcing cladding and a high conductivity cladding.

In some applications of square or rectangular wires it may be preferred for the cladding to surround the wire partially.

In some application a number of wires may be cabled together to manufacture a large mass superconductor. The cable may be clad with a choice reinforcing material and then the clad-cable may be compacted, for example, by drawing to form effectively a singular wire. In another embodiment the cable of wires may be compacted, for example by drawing, and then clad with a choice reinforcing material.

Although the discussion in the above often use NMR and MRI magnets as examples the benefits of reinforcement by cladding of wires with high strength materials is useful to many other superconducting magnets including those used for example in gyrotrons, cyclotrons, and particle beam focusing devices.

Although the present invention has been described with reference to particular embodiments, it will be apparent to those skilled in the art that variations and modifications can be substituted therefor without departing from the scope of the invention as claimed and the particular embodiment(s) hereinbefore described may be varied in construction and detail, e.g. interchanging (where appropriate or desired) different features of each, without departing from the scope of the patent monopoly hereby claimed.

## Claims

1. A method of manufacturing a conductor for a coil intended to be superconductive in operation, comprising the steps of:
(a) providing a conductor having a composite core (10, 12) of superconductor filaments (10) in a matrix (12) of copper metal or alloy, and
(b) cladding the core (10, 12) with a layer (14) of a high-strength reinforcement material having
**characterised in that** said material has an elastic modulus higher than that of pure copper, and **in that** the step of cladding includes at least partially surrounding the core (10,12) by folding said layer (14) about the core (10,12).

2. A method according to Claim 1 wherein, after folding said layer (14) about the core (10,12), the adjacent edges of said folded layer are welded to form a seam.

3. A method according to Claim 1 or Claim 2, wherein said conductor is a nearly complete superconducting wire and said core (10,12) includes multiple filaments (10) of superconducting matter individually contained within and encompassed by said metallic matrix (12).

4. A method according to any preceding Claim, wherein the core (10,12) presents less than a 4:1 ratio of
(a) the metallic matrix (12.), and
(b) said multiple filaments (10).

5. A method according to any preceding Claim, wherein the composite core (10,12) is formed of NbTi-copper, Nb₃Sn-copper or an A15 superconductor filaments-copper, and the cladding (14) is formed of steel or an alloy thereof, of nickel or an alloy thereof, of superalloy, of stainless steel, of molybdenum metal or an alloy thereof, or of another refractory metal or an alloy thereof.

6. A method according to any one of Claims 1 to 5 wherein, subsequent to forming the cladding (14) around the core (10,12), the clad core (10,12,14) is formed into a shape having a circular cross-section.

7. A method according to any one of Claims 1 to 5 wherein, subsequent to forming the cladding (14) around the core (10,12), the clad core (10,12,14) is formed into a shape having a substantially rectangular cross-section.

8. A method as claimed in any one of the preceding Claims, wherein said cladding (14) is applied by at least partially surrounding the composite core (10,12) without forming voids between the cladding (14) and the composite core (10,12).

9. A method as claimed in any one of the preceding Claims, wherein said step of at least partially surrounding the composite core (10,12) comprises the step of folding a continuous sheet layer of the cladding material (14) around the multi-filamentary composite core (10,12)

10. A conductor for a coil intended to be superconductive in operation, the conductor being produced by a method according to any one of Claims 1 to 9 such as to have a composite core (10, 12) of superconductor filaments (10) in a matrix (12) of copper metal or alloy, and cladding about the core (10, 12) formed by a layer (14) of a high-strength reinforce-ment material having **characterised by** an elastic modulus higher than that of pure copper, said cladding at least partially surrounding the core (10,12) and **characterised by** being folded about the core (10,12).

11. A conductor as claimed in claim 10, wherein the multiple superconductor filaments (12) are of Nb-Ti, Nb₃Sn, or another A15 superconductor, and in which the cladding (14) is of steel or an alloy thereof, of nickel or an alloy thereof, of superalloy, of stainless steel, of molybdenum metal or an alloy thereof, or of another refractory metal or an alloy thereof.

12. A conductor as claimed in claim 10 or claim 11, wherein the clad core (10,12,14) has a circular cross-section.

13. A conductor as claimed in claim 10 or claim 11, wherein the clad core (10,12,14) has a cross-section that is substantially rectangular.

14. A conductor as claimed in one any of claims 10 to 13, wherein the cladding (14) comprises stainless steel.

15. A conductor as claimed in any one of claims 10 to 13, wherein the cladding (14) comprises molybdenum or other refractory metal or an alloy thereof

16. A coil intended to be superconductive in operation, said coil comprising a winding formed of at least one conductor (10,12,14) according to any one of Claims 10 to 15.

## Patentansprüche

1. Verfahren zum Herstellen eines Leiters für eine Spule, vorgesehen, um in Betrieb supraleitend zu sein, wobei das Verfahren die folgenden Schritte umfasst:
(a) Bereitstellen eines Leiters mit einem Verbundkern (10, 12) aus Supraleiterfilamenten (10) in einer Matrix (12) aus Kupfermetall oder - legierung und
(b) Umhüllen des Kerns (10, 12) mit einer Schicht (14) aus hochfestem Verstärkungsmaterial
und **dadurch gekennzeichnet ist, dass** das Material einen Elastizitätsmodul hat, der höher als der von reinem Kupfer ist, und **dadurch**, dass der Schritt des Umhüllens wenigstens teilweises Ummanteln des Kerns (10, 12) durch Falten der Schicht (14) um den Kern (10, 12) umfasst.

2. Verfahren nach Anspruch 1, wobei nach dem Falten der Schicht (14) um den Kern (10, 12) die benachbarten Kanten der gefalteten Schicht verschweißt werden, um einen Saum zu bilden.

3. Verfahren nach Anspruch 1 oder 2, wobei der Leiter ein nahezu vollständig supraleitender Draht ist und der Kern (10,12) Multifilamente (10) supraleitenden Materials enthält, die einzeln innerhalb der Metallmatrix (12) enthalten und von dieser umgeben sind.

4. Verfahren nach einem der vorhergehenden Ansprüche, wobei der Kern (10, 12) weniger als ein 4:1-Verhältnis von
(a) der Metallmatrix (12) und
(b) den Multifilamenten (10) darstellt.

5. Verfahren nach einem der vorhergehenden Ansprüche, wobei der Verbundkern (10, 12) aus NbTi-Kupfer, Nb₃Sn-Kupfer oder einem Supraleiterfilamentenkupfer A15 gebildet ist und die Umhüllung (14) aus Stahl oder einer Legierung davon, aus Nickel oder einer Legierung davon, aus Superlegierung, aus Edelstahl, aus Molybdänmetall oder einer Legierung davon oder einem anderen hochschmelzenden Metall oder einer Legierung davon gebildet ist.

6. Verfahren nach einem der Ansprüche 1 bis 5, wobei im Anschluss an das Ausbilden der Umhüllung (14) um den Kern (10, 12) der umhüllte Kern (10, 12, 14) in eine Form gebracht wird, die einen kreisförmigen Querschnitt aufweist.

7. Verfahren nach einem der Ansprüche 1 bis 5, wobei im Anschluss an das Ausbilden der Umhüllung (14) um den Kern (10, 12) der umhüllte Kern (10, 12, 14) in eine Form gebracht wird, die einen im Wesentlichen rechteckigen Querschnitt aufweist.

8. Verfahren nach einem der vorhergehenden Ansprüche, wobei die Umhüllung (14) durch wenigstens teilweises Ummanteln des Verbundkerns (10, 12) aufgebracht wird, ohne Hohlräume zwischen der Umhüllung (14) und dem Verbundkern (10, 12) auszubilden.

9. Verfahren nach einem der vorhergehenden Ansprüche, wobei der Schritt des wenigstens teilweisen Ummantelns des Verbundkerns (10, 12) den Schritt des Faltens einer kontinuierlichen Folienschicht aus Umhüllungsmaterial (14) um den Multifilament-Verbundkern (10, 12) umfasst.

10. Leiter für eine Spule, vorgesehen, um in Betrieb supraleitend zu sein, wobei der Leiter durch ein Verfahren nach einem der Ansprüche 1 bis 9 so hergestellt wird, dass er einen Verbundkern (10, 12) aus Supraleiterfilamenten (10) in einer Matrix (12) aus Kupfermetall oder -legierung und eine aus einer Schicht (14) gebildete Umhüllung über dem Kern (10, 12) aufweist, die aus einem hochfesten Verstärkungsmaterial ist, das **dadurch gekennzeichnet ist, dass** es einen Elastizitätsmodul hat, der höher als der von reinem Kupfer ist, wobei die Umhüllung den Kern (10, 12) wenigstens teilweise ummantelt und **dadurch gekennzeichnet ist, dass** sie um den Kern (10, 12) gefaltet ist.

11. Leiter nach Anspruch 10, wobei die mehreren Supraleiterfilamente (12) aus NbTi, Nb₃Sn oder einem anderen A15-Supraleiter sind und wobei die Umhüllung (14) aus Stahl oder einer Legierung davon, aus Nickel oder einer Legierung davon, aus Superlegierung, aus Edelstahl, aus Molybdänmetall oder einer Legierung davon oder einem anderen hochschmelzenden Metall oder einer Legierung davon ist.

12. Leiter nach Anspruch 10 oder 11, wobei der umhüllte Kern (10, 12, 14) einen kreisrunden Querschnitt hat.

13. Leiter nach Anspruch 10 oder 11, wobei der umhüllte Kern (10, 12, 14) einen Querschnitt hat, der im Wesentlichen rechteckig ist.

14. Leiter nach Anspruch 10 bis 13, wobei die Umhüllung (14) Edelstahl umfasst.

15. Leiter nach Anspruch 10 bis 13, wobei die Umhüllung (14) Molybdän oder anderes hochschmelzendes Metall oder eine Legierung davon umfasst.

16. Spule, die in Betrieb supraleitend sein soll, wobei die Spule eine Wicklung umfasst, die aus wenigstens einem Leiter (10, 12, 14) nach einem der Ansprüche 10 bis 15 gebildet wird.

## Revendications

1. Procédé de fabrication d'un conducteur pour une bobine destinée à être supraconductrice en fonctionnement, comprenant les étapes consistant à :
(a) se procurer un conducteur ayant une âme composite (10, 12) de filaments supraconducteurs (10) dans une matrice (12) de cuivre métallique ou d'alliage ; et
(b) gainer l'âme (10, 12) par une couche (14) de matière de renforcement haute résistance
**caractérisé par le fait que** ladite matière a un module élastique supérieur à celui du cuivre pur, et **par le fait que** l'étape de gainage comprend l'opération consistant à entourer au moins partiellement l'âme (10, 12) par pliage de ladite couche (14) autour de l'âme (10, 12).

2. Procédé selon la revendication 1, dans lequel, après pliage de ladite couche (14) autour de l'âme (10, 12), les bordures adjacentes de ladite couche pliée sont soudées pour former une soudure.

3. Procédé selon la revendication 1 ou la revendication 2, dans lequel ledit conducteur est un fil presque totalement supraconducteur et ladite âme (10, 12) comprend de multiples filaments (10) de matière supraconductrice, contenus individuellement à l'intérieur de et enfermés par ladite matrice métallique (12).

4. Procédé selon l'une quelconque des revendications précédentes, dans lequel l'âme (10, 12) présente moins d'un rapport 4:1 de :
(a) la matrice métallique (12) ; et
(b) lesdits filaments multiples ;

5. Procédé selon l'une quelconque des revendications précédentes, dans lequel l'âme composite (10, 12) est formée de NbTi-cuivre, Nb₃Sn-cuivre ou d'un cuivre pour filaments supraconducteurs A15, et le gainage (14) est formé d'acier ou d'un alliage de celui-ci, de nickel ou d'un alliage de celui-ci, d'un superalliage d'acier inoxydable, de molybdène métallique ou d'un alliage de celui-ci, ou d'un autre métal réfractaire ou d'un alliage de celui-ci.

6. Procédé selon l'une quelconque des revendications 1 à 5, dans lequel, après la formation du gainage (14) autour de l'âme (10, 12), l'âme gainée (10, 12, 14) est façonnée suivant une forme ayant une section transversale circulaire.

7. Procédé selon l'une quelconque des revendications 1 à 5, dans lequel, après la formation du gainage (14) autour de l'âme (10, 12), l'âme gainée (10, 12, 14) est façonnée suivant une forme ayant une section transversale sensiblement rectangulaire.

8. Procédé selon l'une quelconque des revendications précédentes, dans lequel ledit gainage (14) est appliqué par entourage au moins partiel de l'âme composite (10, 12) sans former de vides entre le gainage (14) et l'âme composite (10, 12).

9. Procédé selon l'une quelconque des revendications précédentes, dans lequel ladite étape d'entourage au moins partiel de l'âme composite (10, 12) comprend l'étape de pliage d'une couche de feuille continue de la matière de gainage (14) autour de l'âme composite (10, 12) à filaments multiples.

10. Conducteur pour une bobine destinée à être supraconductrice en fonctionnement, le conducteur étant obtenu par un procédé tel que défini à l'une quelconque des revendications 1 à 9, de façon à avoir une âme composite (10, 12) de filaments supraconducteurs (10) dans une matrice (12) de cuivre métallique ou d'alliage, et un gainage autour de l'âme (10, 12) formé d'une couche (14) d'une matière de renforcement haute résistance, **caractérisée par** un module élastique supérieur à celui du cuivre pur, ledit gainage entourant au moins partiellement l'âme (10, 12) et **caractérisé par le fait qu'**il est plié autour de l'âme (10, 12).

11. Conducteur selon la revendication 10, dans lequel les multiples filaments supraconducteurs (12) sont de Nb-Ti, Nb₃Sn ou un autre supraconducteur A15, et dans lequel le gainage (14) est d'acier ou d'un alliage de celui-ci, de nickel ou d'un alliage de celui-ci, d'un superalliage, d'acier inoxydable, de molybdène métallique ou d'un alliage de celui-ci, ou d'un autre métal réfractaire ou d'un alliage de celui-ci.

12. Conducteur selon la revendication 10 ou la revendication 11, dans lequel l'âme gainée (10, 12, 14) a une section transversale circulaire.

13. Conducteur selon la revendication 10 ou la revendication 11, dans lequel l'âme gainée (10, 12, 14) a une section transversale qui est sensiblement rectangulaire.

14. Conducteur selon l'une quelconque des revendications 10 à 13, dans lequel le gainage (14) comprend un acier inoxydable.

15. Conducteur selon l'une quelconque des revendications 10 à 13, dans lequel le gainage (14) comprend du molybdène ou autre métal réfractaire ou alliage de celui-ci.

16. Bobine destinée à être supraconductrice en fonctionnement, ladite bobine comprenant un enroulement formé d'au moins un conducteur (10, 12, 14), tel que défini à l'une quelconque des revendications 10 à 15.
